# EUROPEAN PATENT SPECIFICATION

(11) **EP 3 323 031 B1**
(45) Date of publication and mention of the grant of the patent: **12.05.2021**
(21) Application number: 16825101.5
(22) Date of filing: 13.07.2016
(51) Int. Cl.: H02J 13/00, H01R 24/78, H01R 24/64, G06F 1/32, G06F 3/14, H01R 13/717, H01R 13/66, G01R 22/10, H01R 25/00, H01R 13/639, G09G 5/00, G06F 1/26, G01R 19/25

(54) **METHOD AND APPARATUS TO RETRIEVE DATA FROM POWER DISTRIBUTION UNITS**
VERFAHREN UND VORRICHTUNG ZUR ERFASSUNG VON DATEN AUS LEISTUNGSVERTEILUNGSEINHEITEN
PROCÉDÉ ET APPAREIL POUR EXTRAIRE DES DONNÉES D'UNITÉS DE DISTRIBUTION D'ÉNERGIE

(30) Priority: 13.07.2015 US 201562191596 P
(43) Date of publication of application: 23.05.2018
(73) Proprietor: Vertiv Corporation, Worthington, OH 43085 (US)
(72) Inventor: HUTCHISON, Gordon, Lincoln, NE 68521 (US); SADECKI, Zachary, Lincoln, NE 68521 (US); NYIRY, Elemer, Lincoln, NE 68521 (US); RILEY, Sam, Lincoln, NE 68521 (US)
(74) Representative: Somervell, Thomas Richard
(86) International application number: PCT/US2016/042071
(87) International publication number: WO 2017/011541

(56) References cited:
- US-A1- 2005 184 886
- US-A1- 2009 262 138
- US-A1- 2011 234 635
- US-A1- 2012 092 060
- US-A1- 2013 049 466
- US-A1- 2014 188 673
- US-B1- 7 964 989
- US-B1- 9 013 283
- US-B2- 7 522 075

## Description

### TECHNICAL FIELD

The present disclosure generally relates to the field of distributing electrical power, and more particularly to a method and apparatus to retrieve data from power distribution units.

### BACKGROUND

Many electronic devices, particularly computer and data storage equipment, are supplied power from an alternating current (AC) electrical power source. For computer and data storage equipment, a power distribution unit (PDU) is typically employed. A typical power distribution unit may include a small display to provide information on current operating conditions. However, the display is too small in order to quickly retrieve and analyze the data associated with the operating conditions of a power distribution unit. US2009/0262138A1 relates to a power distribution unit (PDU) with a self-orienting display which uses an orientation sensor in conjunction with a microprocessor to properly orient visual display of information by one or more displays of the PDU.

### SUMMARY

According to the present invention, there is provided a method and apparatus to retrieve data from a power distribution unit as defined in claims 10 and 1 respectively. Embodiments of the invention are defined in the dependent claims. Apparatus to retrieve data from a power distribution unit includes a processor, memory and display which is coupled to tracking circuitry of a power distribution unit in order to allow viewing of current operating conditions of the power distribution unit. The apparatus is configured to convert data from the tracking circuitry of the power distribution unit into a stream of character sets presented on the display which may be interpreted by a mobile device and translated by the mobile device into human readable information.

It is to be understood that both the foregoing general description and the following detailed description are exemplary and explanatory only and are not necessarily restrictive of the present disclosure. The accompanying drawings, which are incorporated in and constitute a part of the specification, illustrate subject matter of the disclosure. Together, the descriptions and the drawings serve to explain the principles of the disclosure.

### BRIEF DESCRIPTION OF THE DRAWINGS

The numerous advantages of the disclosure may be better understood by those skilled in the art by reference to the accompanying figures in which:
FIG. 1 depicts a flow diagram of a method for retrieving data from a power distribution unit in accordance with an embodiment of the present disclosure;
FIG. 2 depicts a block diagram of an apparatus to retrieve data from a power distribution unit in accordance with an embodiment of the present disclosure;
FIGS. 3A, 3B and 3C depict an apparatus to retrieve data from a power distribution unit in accordance with embodiments of the present disclosure;
FIGS. 4A and 4B depict an apparatus to retrieve data from a power distribution unit contained within an exemplary power distribution unit in accordance with an embodiment of the present disclosure;
FIG. 5 depicts an exemplary mobile device in proximity with an apparatus to retrieve data from a power distribution unit in accordance with an embodiment of the present disclosure;
FIGS. 6A, 6B and 6C depict an exemplary screenshots of an application configured to be executed with a camera device of a mobile device for interpreting the individual character sets on the display of the monitoring device at a frequency not detectable to a human eye;
FIG. 7 depicts a screenshot of an application that includes exemplary operating information of a power distribution unit in accordance with an embodiment of the present disclosure;
FIG. 8 depicts a screenshot of an application of exemplary operating information of a power distribution unit in accordance with an alternative embodiment of the present disclosure;
FIG. 9 depicts a screenshot of an application including a guide for reading data from the monitoring device and a loading indicator in accordance with an embodiment of the present disclosure;
FIG. 10 depicts an auxiliary device for containing an apparatus to retrieve data from a power distribution unit in accordance with an embodiment of the present disclosure; and
FIG. 11 depicts a system for managing a plurality of apparatuses that retrieve data from a power distribution unit in accordance with an embodiment of the present disclosure.

### DETAILED DESCRIPTION

Reference will now be made in detail to the subject matter disclosed, which is illustrated in the accompanying drawings.

Before any embodiments of the disclosure are explained in detail, it is to be understood that the embodiments may not be limited in application per the details of the structure or the function as set forth in the following descriptions or illustrated in the figures. Different embodiments may be capable of being practiced or carried out in various ways. Also, it is to be understood that the phraseology and terminology used herein is for the purpose of description and should not be regarded as limiting. The use of terms such as "including," "comprising," or "having" and variations thereof herein are generally meant to encompass the item listed thereafter and equivalents thereof as well as additional items. Further, unless otherwise noted, technical terms may be used according to conventional usage. It is further contemplated that like reference numbers may describe similar components and the equivalents thereof.

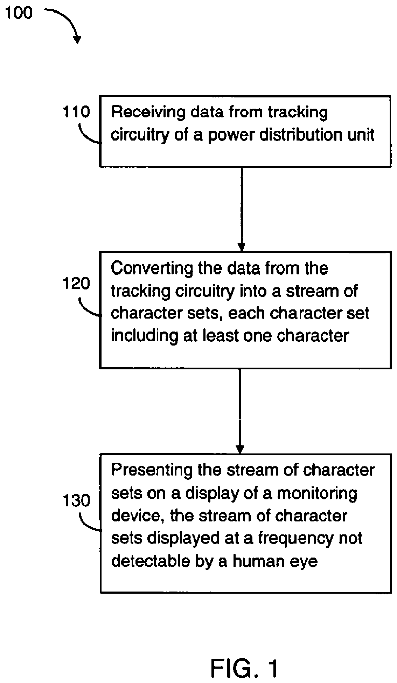

Referring to FIG. 1, a flow diagram of a method 100 for retrieving data from a power distribution unit in accordance with an embodiment of the present disclosure is shown. Method 100 may be executable by a monitoring device coupled to tracking circuitry of a power distribution unit for retrieving data from the power distribution unit. Method 100 may include receiving data from the tracking circuitry of the power distribution unit, the data including operating information of the power distribution unit 110. Method 100 may include converting the data from the tracking circuitry into a stream of character sets 120. It is contemplated that each character set may include at least one character per character set. Method 100 may further include presenting the stream of character sets via a display of a monitoring device 130. It is contemplated that the stream of character sets are presented on the display as individual character sets at a frequency not detectable to a human eye. For example, the character sets may be individually flashed at a frequency in which an individual character set is not detectable to a human eye. For example the stream of character sets may be flashed at a frequency of at least 9 Hertz, and may be at a frequency of 9-15 Hertz, and may be greater than 15 Hertz.

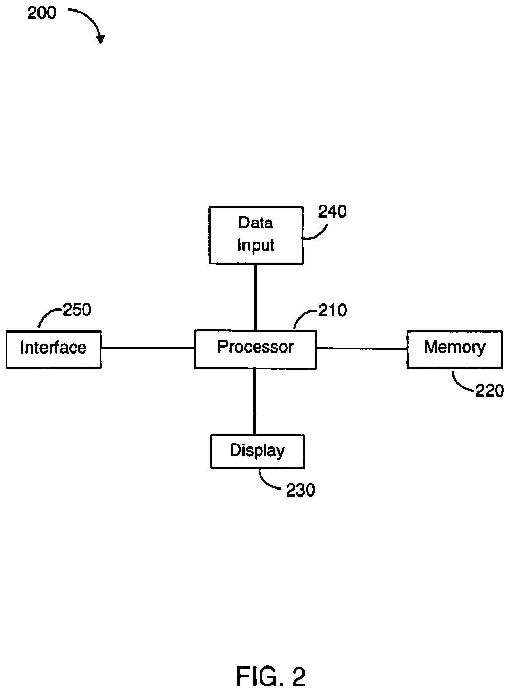

Referring to FIG. 2, a block diagram of an apparatus 200 to retrieve data from a power distribution unit in accordance with an embodiment of the present disclosure is shown. It is contemplated that apparatus 200 to retrieve data from a power distribution unit may be a monitoring device configured to execute method 100 for retrieving data from a power distribution unit as depicted in FIG. 1. It is further contemplated that apparatus 200 and monitoring device may be used interchangeably.

Apparatus 200 may include a processor 210. Apparatus 200 may further include a memory 220 and display 230. It is contemplated that processor 210 may be configured to run various software applications or computer code stored in a non-transitory computer-readable medium, such as memory 220, and configured to execute various instructions or operations. Apparatus 200 may further include a data input device 240. Data input device may be configured to couple with tracking circuitry of a power distribution unit whereby data including operating information of the power distribution unit may be received and processed by processor 210. It is contemplated that data input device may be removably connected with the tracking circuitry. For example, it is contemplated that data input may include a connector to allow removable connection with a cable or set of leads coupled with tracking circuitry of a power distribution unit. Apparatus 200 may further include an interface 250. Interface 250 may include one or more ports for coupling with other devices and may further include one or more buttons to control operation of apparatus 200. Buttons may include a hard reset, an adjustment of dynamic or static display, adjustment of an orientation of display, and the like. It should be understood that display 230 may include a touch screen which may further allow user to interface with apparatus 200. Additionally, it is contemplated that apparatus 200 may further include a housing which may be configured to be contained within a power distribution unit.

It is contemplated that display 230 may be a light emitting diode (LED) display. LED displays may be arranged in a singular or plural configuration. Any color may be utilized. LED displays may include common 7-segment, 14-segment and dot-matrix LED display modules.

However, it is contemplated that various types of displays may be operable. For example, essentially any visual interface may be manipulated to transmit data at a frequency that is not detectable to a human eye. There may be 1 to n number of displays to present simply binary data. For example, 7 LEDs arranged in a row may provide 128 unique combinations. Liquid crystal display (LCD) technology may rapidly display compact QR codes for example, as well as displaying static information. Liquid crystal displays may be arranged as an alphanumeric, graphical or dot matrix style. LCDs may be available as transmissive (with backlight), reflective (no backlight, relying on ambient light for readability) and transflective (a combination of transmissive and reflective technologies). Electroluminescent displays may be employed. Electroluminescent displays may be compact and may include unusual geometries that may be obtained. Typically, electroluminescent displays may be used as LCD backlights, but wafer thin electroluminescent display panels maybe cut into unusual shapes to create an impressive custom display. Vacuum fluorescent displays may be employed. Vacuum fluorescent displays may emit a bright light with high contrast, in one or more colors. Vacuum fluorescent displays may be manufactured to display seven-segment numerals, multi-segment alpha-numeric characters or may be made in a dot-matrix to display different alphanumeric characters and symbols. There is little limit to the shape of the image that may be displayed for vacuum fluorescent displays; it may depend solely on the shape of phosphor on the anodes.

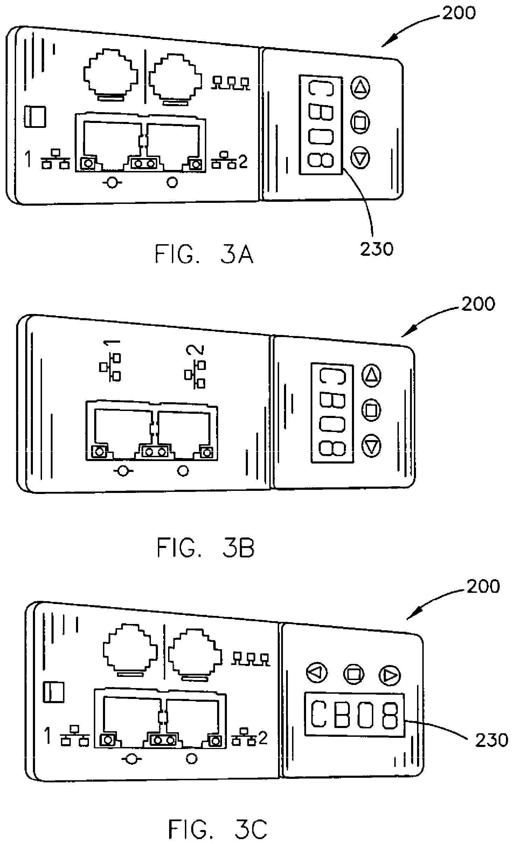

Referring to FIGS. 3A, 3B and 3C, an apparatus 200 to retrieve data from a power distribution unit in accordance with embodiments of the present disclosure are shown. It is contemplated that interface 250 may include buttons to control operation of apparatus 200 and may include various ports to allow communication with other devices. It is further contemplated that apparatus 200 may include a display 230. Display 230 may be oriented in a generally horizontal direction or generally vertical direction in order to suit the needs of various users.

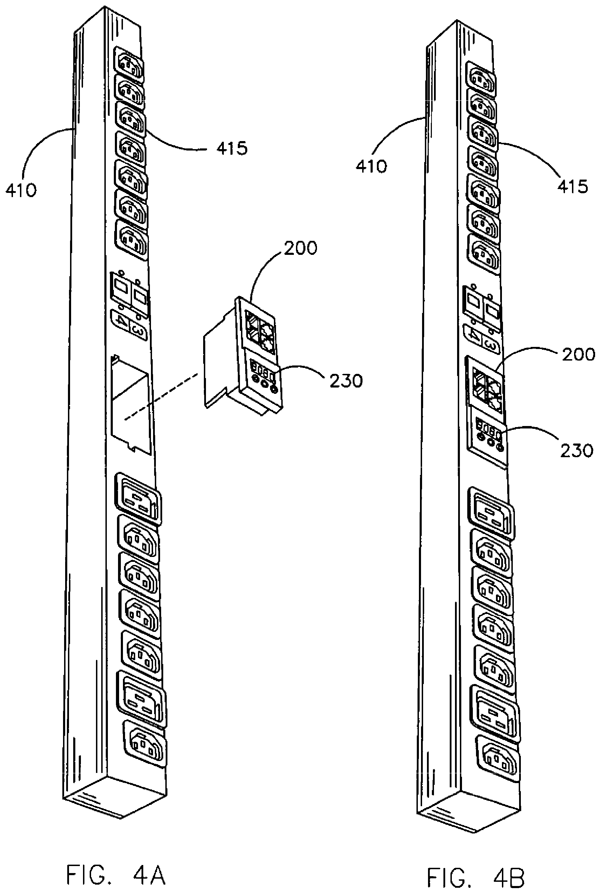

Referring to FIGS. 4A and 4B, an apparatus 200 to retrieve data from a power distribution unit contained within an exemplary power distribution unit 410 in accordance with an embodiment of the present disclosure is shown. Apparatus 200 may include a display 230 and may include a housing which may be removably installed and replaced within a power distribution unit 410. It is contemplated that power distribution unit 410 may include a long, thin housing which may contain at least one receptacle 415, or outlet plug, to distribute power to devices coupled to the receptacle or outlet plug. Power distribution unit 410 may include an input power cable (not shown). Internal to the power distribution unit, a plurality of relays and/or circuit breakers may be included which may isolate other circuits or receptacles. Power distribution unit 410 may further include tracking circuitry which may track operating conditions of the power distribution unit 410, such as serial number, circuit configuration, outlet count, voltage, current and power available at the various circuits of the power distribution unit 410. For example, tracking circuitry may include one or more sensors and meters to track Amperes, Volts, watts, VA, kWhr and may further track environmental data such as temperature, humidity, and contact status. Tracking circuity may include one or more cables, coupled to one or more sensors or meters to transfer operating information data to data input device 240 of apparatus 200.

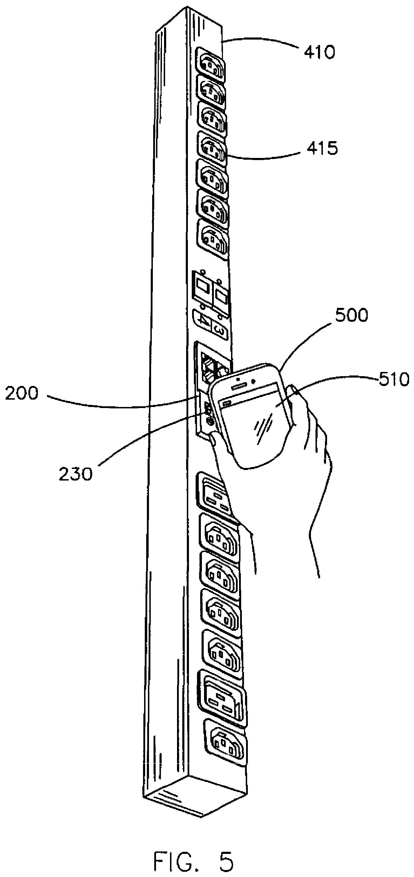

Referring to FIG. 5, an exemplary mobile device 500 in proximity with an apparatus 200 to retrieve data from a power distribution unit in accordance with an embodiment of the present disclosure is shown. As previously described, display 230 of apparatus 200 may be configured to present a stream of character sets. The stream of character sets may be presented on the display 230 as individual character sets at a frequency not detectable to a human eye. For example, the character sets may be individually flashed at a frequency in which an individual character set is not detectable to a human eye. For example the stream of character sets may be flashed at a frequency of at least 9 Hertz, and may be at a frequency of 9-15 Hertz, and may be greater than 15 Hertz. Advantageously, significantly more information may be presented from the limited space of a display 230 to be acquired from the power distribution unit in a quicker period of time than what can be provided by a conventional display.

As shown in FIG. 5, it is contemplated that a mobile device 500 utilizing an integrated camera device operating an application may be configured to read the character sets which may be individually flashed at a frequency in which an individual character set is not detectable to a human eye. Mobile device 500 may employ a camera feature through the application and may scan the output of the display 230 and convert the character sets into human readable information presented on a display 510 of the mobile device 500. It is contemplated that the application to interpret the character sets from display may be a mobile device application, often referred as an app, executed by a processor of one or more mobile computing devices (e.g. iPhones and Android devices, tablets and the like).

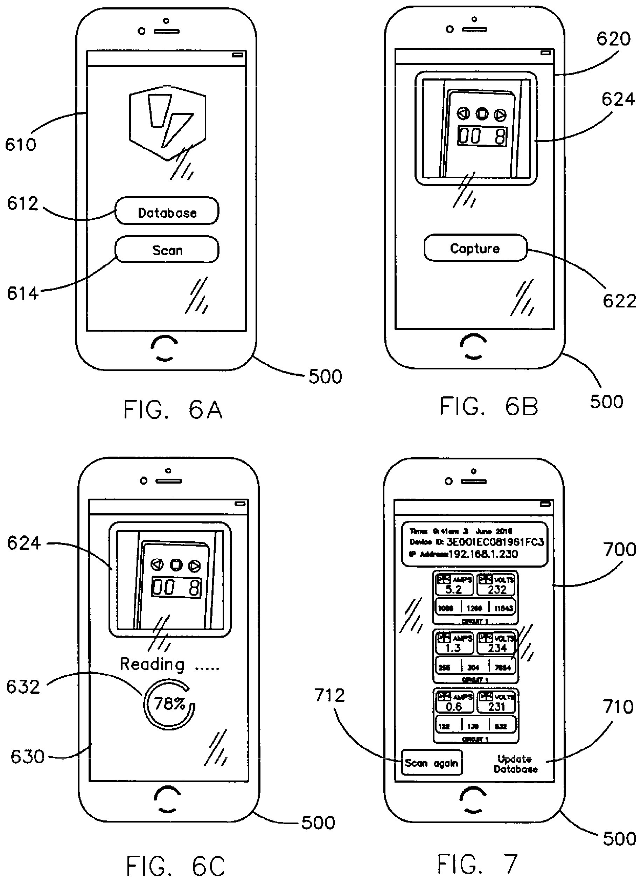

Referring to FIG. 6A, 6B and 6C, exemplary screenshots of an application configured to be executed with a camera device of a mobile device for interpreting the individual character sets on the display of the monitoring device at a frequency not detectable to a human eye are shown. Referring specifically to FIG. 6A, screenshot 610 may include an icon to access a database 612 and an icon to begin a scan 614. It is contemplated that application may include a database, local and/or cloud-server based, which may include information about prior readings of power distribution units which can be used to compare with a current reading. The collection of operating information including identification information into a local database may provide for simple cabinet to cabinet local data logging. Additionally, operating information may be downloaded through an email or other transfer process for manipulation by external source (e.g. Excel).

Upon initiation of the scan 614 of the screenshot 610 of FIG. 6A, a screenshot 620 may be initiated as shown in FIG. 6B. Screenshot 620 may include a capture icon 622 to begin capture of the character sets being presented on a display 230 of apparatus 200. Screenshot 620 may further include a camera display portion 624 which shows the image of what is currently being captured by a camera device of the mobile device 500. It is contemplated that a user may hold the mobile device 500 whereby the display 230 of apparatus 200 may be visible in the camera display portion 624. After a user activates the capture icon 622, the mobile device may begin reading the character sets of display 230 of apparatus 200. Upon activation of the capture icon 622, it is contemplated that screenshot 630 of FIG. 6C may be initiated. Screenshot 630 may include camera display portion 624 and may also include a reading completion icon 632 which may indicate a percentage of completion of the reading.

Referring to FIG. 7, a screenshot 700 of an application that includes exemplary operating information of a power distribution unit in accordance with an embodiment of the present disclosure is shown. It is contemplated that the application executed by the processor of mobile device 500 may interpret the character sets and may produce the operating information of a power distribution unit. The operating information may include a time stamp, device identification, an IP address, along with voltage and current information. Screenshot 700 may include an update database icon 710 and a scan again icon 712. The update database icon 710 may initiate archival storage of the operating information within a database. The scan again icon 712 may initiate another scan and may initiate screenshot 620 of FIG. 6B to repeat the process to complete a scan. It is contemplated that screenshot 700 may only be initiated if the data capture has been validated by an integrated error-checking algorithm. For example, the integrated error-checking algorithm may ensure that the application may only display data it has validated as correct and therefore prevent error and omissions from being stored in the database.

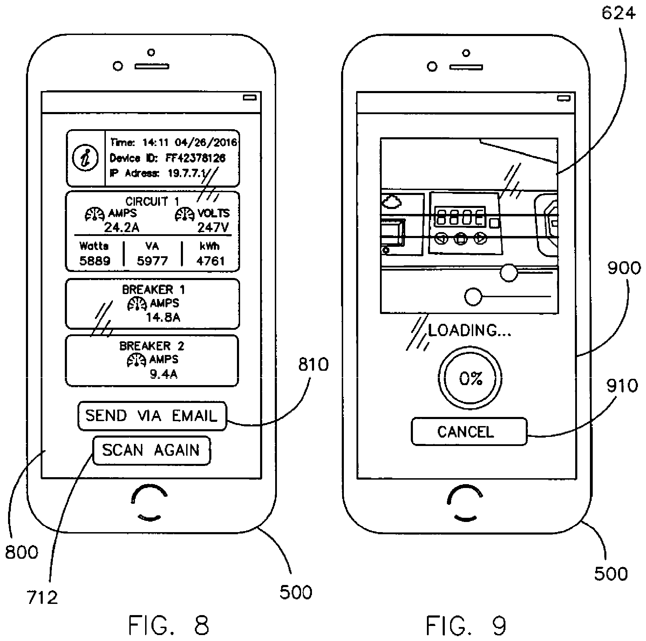

Referring to FIG. 8, a screenshot 800 of an application of exemplary operating information of a power distribution unit in accordance with an alternative embodiment of the present disclosure is shown. It is contemplated that the application executed by the processor of mobile device 500 may interpret the character sets and may produce the operating information of a power distribution unit. The operating information may include a time stamp, device identification, an IP address, along with voltage and current information. It is further contemplated that power consumption, electrical power consumption, and specific breaker information may be presented. Screenshot 800 may include an scan again icon 712. Screenshot 800 may further include a send via email icon 810 which may initiate an email message to be sent to a desired address which includes the operating information that has just been read.

Referring to FIG. 9, a screenshot 900 of an application including a guide for reading data from the monitoring device and a loading indicator in accordance with an embodiment of the present disclosure is shown. Screenshot 900 may include a camera display portion 624 which shows the image of what is currently being captured by a camera device of the mobile device 500. Screenshot 900 may further include a cancel icon 910 which may terminate a scan. As shown in FIG. 9, it is contemplated that camera display portion 624 may include a guide to aid the user in reading the character sets of a display 230 of apparatus 200. In one embodiment, guide may refer to two lines whereby the character sets should be placed within the two lines. Other types of guides may include a transparent but highlighted area to allow a user to more easily capture the character sets of a display 230 of apparatus 200. It is further contemplated that camera display portion 624 may include on display control icons including an exposure adjustment and a zoom adjustment to more quickly enhance data capture of a display 230 for a user. It is also contemplated that the sliding dial may be employed which depicts a percentage (0%-100%) of data successfully captured. This scale can decrease as well as increase if the capture accuracy is poor to enable a user to adjust orientation of the mobile device 500, the exposure adjustment or zoom adjustment to increase scanning speed and accuracy.

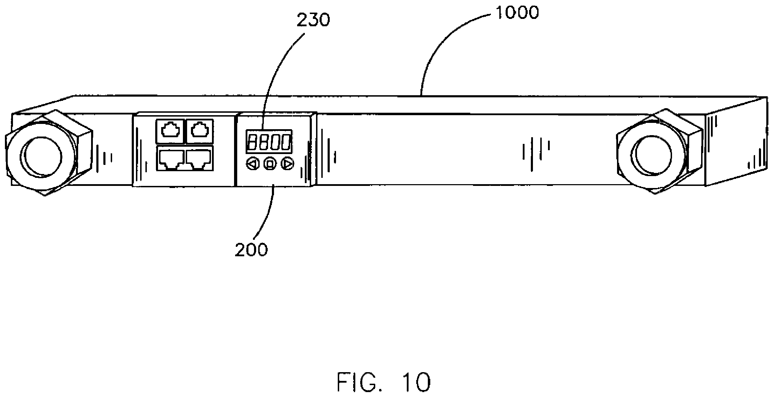

Referring to FIG. 10, an auxiliary device 1000 for containing an apparatus 200 to retrieve data from a power distribution unit in accordance with an embodiment of the present disclosure is shown. Auxiliary device 1000 may be easily installed within a computer or server rack and may allow apparatus 200 to be coupled with a power distribution unit. It is contemplated that auxiliary device 1000 may be employed when a user desires use of apparatus 200 but the power distribution unit may not contain space for housing apparatus 200.

While it is contemplated that display 230 of apparatus 200 may be configured to present each character set including at least one character, the stream of character sets presented on the display 230 as individual character sets at a frequency may not be detectable to a human eye. However, it is contemplated that display 230 may further be configured to present data that is visible to the human eye. Display 230 may further be configured to present individual character sets at a frequency may not be detectable to a human eye. Additionally, display 230 may present characters in two independent but concurrent streams, such as a master and sub stream. The master stream refresh and persistence rates are such that they can be seen by the human eye, the sub stream refresh and persistence rates may be presentation of individual character sets at a frequency may not be detectable to a human eye.

It is contemplated that a character of a character set may include a symbol, a letter, a numeral or a hexadecimal digit. An example of a possible codec is to display a hexadecimal digit (0-9,A-F) such that each character pair would represent one byte of data. In one embodiment, character set may include four hexadecimal digits whereby each individual character set may provide two bytes of data. Therefore, it is contemplated that an 80 byte data stream, in the four hexadecimal digit example, may use 40 individual character sets. A current advantage of using hexadecimal digits is that current mobile device operating systems such as Google Android and Apple iOS have text recognition built into the base operating system so additional sophisticated computer vision programing or third party software would not be necessary to interpret the display into a data stream. However, other codecs may be possible using 7 segments of each light emitting diode (LED) which may provide higher data compression, although these may employ a more bespoke decoding approach to process the camera image.

The frequency of the character sets may only be limited by the capabilities of the image capturing hardware of mobile device 500. It is contemplated that most standard mobile device hardware available at this time may be able to capture character sets at a frequency of at least 15 Hertz, in which a full data capture of 40 character sets may be achieved in less than 3 seconds. It is contemplated that many current mobile devices may be able to achieve much higher frequencies with 40 character sets being able to be captured in less than 1 second. As the performance of mobile device cameras increases, the capture time may be reduced.

It is contemplated that an exemplary data set may include 80 bytes. In an embodiment of the disclosure, the breakdown of the data set and the exemplary operating information may include:
Frame Sync
Frame Definition (may provide a number of character sets in the data set)
Device Identification (may provide serial number and outlet count)
IP Address
Input Circuit (up to 3):
   Voltage
   Amps
   Watts
   Volt-Amperes
   Energy: 5 bytes (integer kWHr)
   Cyclic Redundancy Check data

It is contemplated that under the exemplary data distribution, the total data set may include 80 bytes of data if all 3 circuits are transmitted. If there is 1 byte per character, 4 simultaneously displayed characters may employ 20 character sets. Nyquist sampling theory may require data capture at 2 times a display cycle speed. For example, a 15 Hertz frequency may require a 30 fps camera device which is present in most current mobile devices, resulting in a total capture time of less than two seconds.

In addition to device identification, it is contemplated that meta-tags related to a power distribution unit may be enabled to be associated with different events, activities or operations such as: function, location, application, electrical supply and customer. Each power distribution unit may have multiple meta-tags assigned to it and as such they may be associated with multiple scanning and scheduled updates. It is further contemplated that a secure scan mode may be enabled whereby managers may configure particular power distribution units that may be scanned by designated personnel only.

It is contemplated that the application executed on the mobile device 500 may operate with a database, which may be an in-app database. Each power distribution unit may be identified via the serial number and new data points may be logged and stored or new devices may be added. It is contemplated that user-defined fields may be available. The application configuration may freely move through both iOS and Android devices by means of an import/export database. This allows one user to setup a desired database and then clone it to any number of supported mobile devices. Additionally, the app may be configured to graph and export via comma-separated values (CSV) through electronic mail messages or to a cloud-based server.

Exemplary data collection for a power distribution unit may include:
1. Aggregation based on user fields (e.g. total kWh per row)
2. Set thresholds per identification device
3. Set global thresholds
4. Local alarms
5. Remote alarming (SMS/email)
6. Reminders
7. Work flow
8. Device positioning through GPS and iBeacon

While the foregoing description and figures have described a method and apparatus of visible light communication from apparatus 200 to a mobile device 500, it is contemplated that apparatus 200 may also be configured to receive visible light communication. It is contemplated that full duplex communication may be implemented with mobile device 500 while maintaining a zero contact approach. Apparatus 200 may include a light sensitive element, a light sensor, whereby the mobile device 500 may be configured to send data via visible light communication to apparatus 200. It is contemplated that mobile device 500 may be configured for visible light communication through its display, through a peripheral component coupled to the mobile device 500, or through an integrated flash of the mobile device 500.

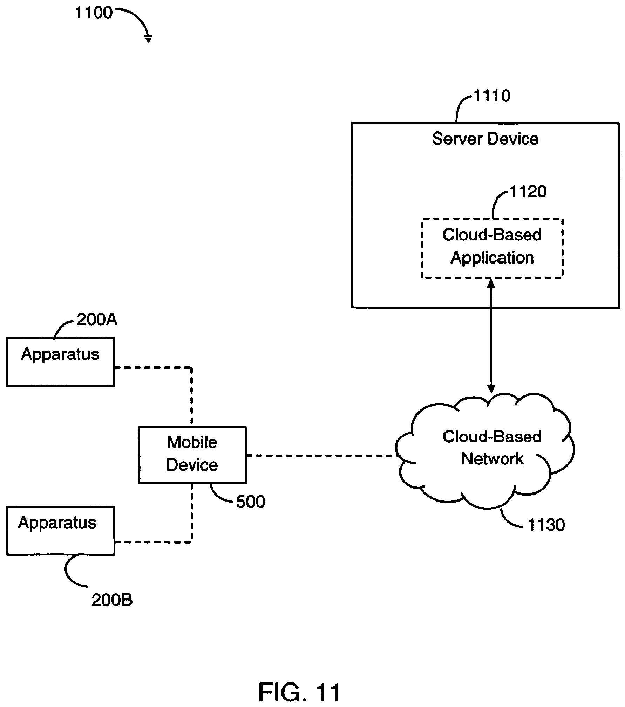

Referring to FIG. 11, a system 1100 for managing a plurality of apparatuses 200A, 200B that retrieve data from a power distribution unit in accordance with an embodiment of the present disclosure is shown. Apparatuses 200A, 200B may be referred as monitoring devices and may refer to a plurality of devices as previously described as apparatus 200. System 1100 may include a server device 1110 which may include a cloud-based application 1120. The cloud-based application 1120 implemented on the cloud-based server device 1110 may provide various interfaces facilitating the managing of a plurality of apparatuses 200A, 200B and their respective power distribution units. Additionally, cloud-based application 1120 implemented on cloud-based server device 1110 may provide an interface for cloud-based data storage via a database that may maintain operating information for each power distribution unit.

Server device 1110 may be configured to communicate with mobile device 500 via a cloud-based network 1130 (e.g. the internet) using the built-in wireless capabilities of the mobile device 500. Once a secure connection has been established and verified between the server device 1110 and mobile device 500, the operating information for various power distribution units via apparatuses 200A, 200B may be transferred to a cloud-based database residing on a cloud-based server device 1110 (e.g. a web server accessible over a web-browser or application implemented on the mobile device 500). The cloud-based server device 1110 may implement at least one cloud-based application 1120 accessible by a mobile device 500 and/or one or more additional network devices such as a laptop or desktop computer.

In an example embodiment, through the web-browser software, a user can use a computer to log on to cloud-based services (e.g., by the web-browser software resident on the computer communicating with cloud-based server device 1110) to access a cloud-based application 1120. After logging-on to the cloud-based application 1120, the user may create, edit, save and delete files on cloud-based server device 1110, and may establish (set up) or change/edit various options, such as user preferences and/or system settings, and/or may receive or download software (e.g., operating system or other software) or software updates, various data files or media files, user preferences and/or system settings, and other information previously stored on the cloud-based server device 1110, via the cloud-based application 1120 running on the cloud-based server device 1110.

It is contemplated that server device 1110 operating cloud-based application 1120 may monitor a location of mobile device 500 to improve work flow management. Personnel may be directed and prioritized based upon system requirements and current locations of individuals. Mobile device 500 may implement Real Time Location Services (RTLS) to simultaneously associate coordinates of the mobile device 500 with receipt of operating information from apparatuses 200A, 200B. RTLS may be implemented through the use of any available "standards-based" location services platform including, but not limited to: GPS, Wireless LAN, Cellular Services, Radio Frequency Identification, and Infrared Signal. It is contemplated that other additional location identification mechanisms may also be employed, particularly for use within premises. Location awareness and maintenance of data on cloud-based server device 1110 may monitor and report on energy costs at various locations. A cost per energy unit (kWh) may also be maintained to derive customer billing information.

It is contemplated that system 1100 may be configured to operate in a variety of modes to support management of a plurality of apparatuses 200A, 200B that retrieve data from a power distribution unit in accordance with an embodiment of the present disclosure. For example, particular products may be assigned and location may be maintained. The app executable on the mobile device 500 may provide directions for setup of a device, its location, and its presence such as specification, power supply, location, application, customer details. The app executable on the mobile device 500 may keep track of every unit and the timeframe in which the unit needs to be re-scanned/updated. The app may further remind users of power distribution units that need updating and the location of the unit(s) that have not been updated. It is further contemplated that the application may use the operating information to obtain phase load utilization per power distribution unit breaker/Phase, rack, row, hall and the like. Through storage of the settings and configuration details of a power distribution unit, replacement and reconfiguration may be improved.

It is contemplated that method and apparatus to retrieve data from a power distribution unit as shown and described with respect to FIGS. 1-11 may provide a number of advantages to users. The advantages may include presentation of much more information than may be made available locally using a simple display. The end user presentation, depicted in FIGS. 7 and 8, may be presented better without a requirement of a large local display which is more expensive and uses significantly more surface space on the power distribution unit. Also, the mobile device 500 may be paired with the apparatus 200 without any complex requirements; no Bluetooth or Ethernet connectivity may be required.

It is contemplated that method and apparatus to retrieve data from a power distribution unit as shown and described with respect to FIGS. 1-11 may also provide a number of advantages to manufacturers of power distribution units. These advantages may include avoiding a need to develop a larger, more feature rich, display located on the power distribution unit. As all information associated with a power distribution unit may be transmitted (such as IP address, serial number, and all power information), the onward development potential may be very high. Additionally, apparatus 200 may be configured to provide air gapping which may refer to an industry term of providing a network air-gap. A network air-gap may allow physical isolation between products or networks. True physical isolation may be required to uphold the air-gap and the use of visible light communication in half-duplex and full-duplex configuration allows data to cross from one network to another via a controlled air-gap. The visible light communication supported by apparatus 200 which improves security by effectively isolating equipment from the outside world beyond firewalls, encryption systems, and the like.

It is to be understood that both the foregoing general description and the following detailed description are exemplary and explanatory only and are not necessarily restrictive of the present disclosure. The accompanying drawings, which are incorporated in and constitute a part of the specification, illustrate subject matter of the disclosure. Together, the descriptions and the drawings serve to explain the principles of the disclosure.

## Claims

1. An apparatus (200) for retrieving data from a power distribution unit (410), comprising:
a monitoring device, the monitoring device configured to be contained within a power distribution unit, the monitoring device including a processor (210), memory (220) and display (230), wherein the monitoring device is configured to be coupled with tracking circuitry of the power distribution unit to obtain operating information for the power distribution unit and convert the operating information into a stream of character sets, each character set including at least one character,
**characterized in that** the stream of character sets are presented as individual character sets on the display at a frequency of at least 9 Hertz such that they are not detectable to a human eye.

2. The apparatus as claimed in claim 1, wherein the at least one character includes a symbol, a letter, a numeral or a hexadecimal digit.

3. The apparatus as claimed in claim 1, wherein the character set includes at least two characters.

4. The apparatus as claimed in claim 1, wherein the character set includes four characters of hexadecimal digits.

5. The apparatus as claimed in claim 1, wherein the operating information includes device identification information, voltage and current.

6. The apparatus as claimed in claim 1, wherein said monitoring device further includes at least one interface button configured to control at least one operation of the monitoring device.

7. A system comprising the apparatus as claimed in any preceding claim and a power distribution unit (410), the power distribution unit including at least one power receptacle (415) configured to supply power and tracking circuitry configured to provide operating information for the power distribution unit, wherein the monitoring device is configured to be contained within the power distribution unit, and wherein the monitoring device is configured to be coupled with the tracking circuitry of the power distribution unit.

8. A system comprising the apparatus as claimed in any one of claims 1-6 and a mobile device (500), the mobile device comprising a camera device configured to read the stream of character sets on the monitoring device display (230).

9. The system as claimed in claim 8, wherein the mobile device is configured to convert the stream of character sets on the display of the monitoring device into human readable information presented on a display of the mobile device (510).

10. A method (100), executable by a monitoring device coupled to tracking circuitry of a power distribution unit, for retrieving data from the power distribution unit (110), comprising:
receiving data from the tracking circuitry of the power distribution unit (110), the data including operating information of the power distribution unit;
converting the data from the tracking circuitry into a stream of character sets (120); and
presenting the stream of character sets on a display of the monitoring device,
**characterized in that** the stream of character sets is presented as individual character sets on the display of the monitoring device at a frequency of at least 9 Hertz such that they are not detectable to a human eye (130).

11. The method as claimed in claim 10, wherein the at least one character includes a symbol, a letter, a numeral or a hexadecimal digit.

12. The method as claimed in claim 10, wherein a camera device of a mobile device is configured to read the stream of character sets on the display.

13. The method as claimed in claim 12, wherein the mobile device is configured to convert the stream of character sets on the display of the monitoring device into human readable information presented on a display of the mobile device.

14. The method as claimed in claim 10, wherein the character set includes four characters of hexadecimal digits.

## Patentansprüche

1. Vorrichtung (200) zum Erfassen von Daten von einer Leistungsverteilungseinheit (410), umfassend:
eine Überwachungsvorrichtung, wobei die Überwachungsvorrichtung konfiguriert ist, um innerhalb einer Leistungsverteilungseinheit enthalten zu sein, wobei die Überwachungsvorrichtung einen Prozessor (210), einen Speicher (220) und eine Anzeige (230) umfasst, wobei die Überwachungsvorrichtung konfiguriert ist, um mit einer Verfolgungsschaltung der Leistungsverteilungseinheit gekoppelt zu sein, um Betriebsinformationen für die Leistungsverteilungseinheit zu erhalten und die Betriebsinformationen in einen Strom von Zeichensätzen umzuwandeln, wobei jeder Zeichensatz mindestens ein Zeichen umfasst,
**dadurch gekennzeichnet, dass** der Strom von Zeichensätzen als einzelne Zeichensätze auf der Anzeige mit einer Frequenz von mindestens 9 Hz präsentiert wird, sodass diese von einem menschlichen Auge nicht erkennbar sind.

2. Vorrichtung nach Anspruch 1, wobei das mindestens eine Zeichen ein Symbol, einen Buchstaben, eine Zahl oder eine Hexadezimalziffer umfasst.

3. Vorrichtung nach Anspruch 1, wobei der Zeichensatz mindestens zwei Zeichen umfasst.

4. Vorrichtung nach Anspruch 1, wobei der Zeichensatz vier Zeichen von Hexadezimalziffern umfasst.

5. Vorrichtung nach Anspruch 1, wobei die Betriebsinformationen Vorrichtungsidentifikationsinformationen, Spannung und Strom umfassen.

6. Vorrichtung nach Anspruch 1, wobei die Überwachungsvorrichtung ferner mindestens einen Schnittstellendruckknopf umfasst, welcher konfiguriert ist, um mindestens eine Operation der Überwachungsvorrichtung zu steuern.

7. System, umfassend die Vorrichtung nach einem der vorhergehenden Ansprüche und eine Leistungsverteilungseinheit (410), wobei die Leistungsverteilungseinheit mindestens eine Steckdose (415) umfasst, welche zur Stromversorgung konfiguriert ist, und eine Verfolgungsschaltung, welche konfiguriert ist, um Betriebsinformationen für die Leistungsverteilungseinheit bereitzustellen, wobei die Überwachungsvorrichtung konfiguriert ist, um innerhalb der Leistungsverteilungseinheit enthalten zu sein, und wobei die Überwachungsvorrichtung konfiguriert ist, um mit der Verfolgungsschaltung der Leistungsverteilungseinheit gekoppelt zu sein.

8. System, umfassend die Vorrichtung nach einem der Ansprüche 1 bis 6 und eine mobile Vorrichtung (500), wobei die mobile Vorrichtung eine Kameravorrichtung umfasst, welche konfiguriert ist, um den Strom von Zeichensätzen auf der Überwachungsvorrichtungsanzeige (230) zu lesen.

9. System nach Anspruch 8, wobei die mobile Vorrichtung konfiguriert ist, um den Strom von Zeichensätzen auf der Anzeige der Überwachungsvorrichtung in menschenlesbaren Informationen umzuwandeln, welche auf einer Anzeige der mobilen Vorrichtung (510) präsentiert werden.

10. Verfahren (100), welches durch eine Überwachungsvorrichtung ausführbar ist, welche mit einer Verfolgungsschaltung einer Leistungsverteilungseinheit gekoppelt ist, um Daten von der Leistungsverteilungseinheit (110) abzurufen, umfassend:
Empfangen von Daten von der Verfolgungsschaltung der Leistungsverteilungseinheit (110), wobei die Daten Betriebsinformationen der Leistungsverteilungseinheit umfassen;
Umwandeln der Daten für die Verfolgungsschaltung in einen Strom von Zeichensätzen (120); und
Präsentieren des Stroms von Zeichensätzen auf einer Anzeige der Überwachungsvorrichtung,
**dadurch gekennzeichnet, dass** der Strom von Zeichensätzen als einzelne Zeichensätze auf der Anzeige der Überwachungsvorrichtung mit einer Frequenz von mindestens 9 Hz präsentiert wird, sodass diese von einem menschlichen Auge (130) nicht erkennbar sind.

11. Verfahren nach Anspruch 10, wobei das mindestens eine Zeichen ein Symbol, einen Buchstaben, eine Zahl oder eine Hexadezimalziffer umfasst.

12. Verfahren nach Anspruch 10, wobei eine Kameravorrichtung einer mobilen Vorrichtung konfiguriert ist, um den Strom von Zeichensätzen auf der Anzeige zu lesen.

13. Verfahren nach Anspruch 12, wobei die mobile Vorrichtung konfiguriert ist, um den Strom von Zeichensätzen auf der Anzeige der Überwachungsvorrichtung in menschenlesbaren Informationen umzuwandeln, welche auf einer Anzeige der mobilen Vorrichtung präsentiert werden.

14. Verfahren nach Anspruch 10, wobei der Zeichensatz vier Zeichen von Hexadezimalziffern umfasst.

## Revendications

1. Appareil (200) permettant d'extraire des données d'une unité de distribution d'énergie (410), comprenant
un dispositif de surveillance, le dispositif de surveillance étant configuré pour être contenu dans une unité de distribution d'énergie, le dispositif de surveillance incluant un processeur (210), une mémoire (220) et un écran (230), dans lequel le dispositif de surveillance est configuré pour être raccordé à un circuit de suivi de l'unité de distribution d'énergie afin d'obtenir des informations opérationnelles pour l'unité de distribution d'énergie et convertir les informations opérationnelles en un flux d'ensembles de caractères, chaque ensemble de caractère incluant au moins un caractère,
**caractérisé en ce que** le flux d'ensembles de caractères est présenté comme des ensembles de caractères individuels à l'écran à une fréquence d'au moins 9 Hertz, de sorte qu'ils ne soient pas détectables à l'œil humain.

2. Appareil selon la revendication 1, dans lequel le au moins un caractère inclut un symbole, une lettre, un chiffre ou un chiffre hexadécimal.

3. Appareil selon la revendication 1, dans lequel l'ensemble de caractères inclut au moins deux caractères.

4. Appareil selon la revendication 1, dans lequel l'ensemble de caractères inclut quatre caractères de chiffres hexadécimaux.

5. Appareil selon la revendication 1, dans lequel les informations opérationnelles incluent des informations d'identification du dispositif, la tension et le courant.

6. Appareil selon la revendication 1, dans lequel ledit dispositif de surveillance inclut en outre au moins un bouton d'interface configuré pour commander au moins une opération du dispositif de surveillance.

7. Système comprenant l'appareil selon l'une quelconque des revendications précédentes, et une unité de distribution d'énergie (410), l'unité de distribution d'énergie incluant au moins un réceptacle d'énergie (415) configuré pour fournir de l'énergie et un circuit de suivi configuré pour fournir des informations opérationnelles pour l'unité de distribution d'énergie, dans lequel le dispositif de surveillance est configuré pour être contenu dans l'unité de distribution d'énergie, et dans lequel le dispositif de surveillance est configuré pour être couplé au circuit de suivi de l'unité de distribution d'énergie.

8. Système comprenant l'appareil selon l'une quelconque des revendications 1 à 6, et un dispositif mobile (500), le dispositif mobile comprenant un dispositif de caméra configuré pour lire le flux d'ensembles de caractères sur l'écran du dispositif de surveillance (230).

9. Système selon la revendication 8, dans lequel le dispositif mobile est configuré pour convertir le flux d'ensembles de caractères sur l'écran du dispositif de surveillance en informations lisibles par l'homme présentées sur un écran du dispositif mobile (510).

10. Procédé (100), exécutable par un dispositif de surveillance couplé à un circuit de suivi d'une unité de distribution d'énergie, permettant d'extraire des données de l'unité de distribution d'énergie (110), comprenant :
la réception de données du circuit de suivi de l'unité de distribution d'énergie (110), les données incluant des informations opérationnelles de l'unité de distribution d'énergie ;
la conversion des données du circuit de suivi en un flux d'ensembles de caractères (120) ; et
la présentation du flux d'ensembles de caractères sur un écran du dispositif de surveillance,
**caractérisé en ce que** le flux d'ensembles de caractères est présenté comme des ensembles de caractères individuels sur l'écran du dispositif de surveillance à une fréquence d'au moins 9 Hertz, de sorte qu'ils ne soient pas détectables par l'œil humain (130).

11. Procédé selon la revendication 10, dans lequel le au moins un caractère inclut un symbole, une lettre, un chiffre ou un chiffre hexadécimal.

12. Procédé selon la revendication 10, dans lequel un dispositif de caméra d'un dispositif mobile est configuré pour lire le flux d'ensembles de caractères sur l'écran.

13. Procédé selon la revendication 12, dans lequel le dispositif mobile est configuré pour convertir le flux d'ensembles de caractères sur l'écran du dispositif de surveillance en informations lisibles par l'homme présentées sur un écran du dispositif mobile.

14. Procédé selon la revendication 10, dans lequel l'ensemble de caractères inclut quatre caractères de chiffres hexadécimaux.
